(19) **Europäisches Patentamt / European Patent Office / Office européen des brevets**

(11) **EP 4 637 177 A1**

(12) **EUROPEAN PATENT APPLICATION**
published in accordance with Art. 153(4) EPC

(43) Date of publication:
22.10.2025 Bulletin 2025/43

(21) Application number: 22968645.6

(22) Date of filing: 22.12.2022

(51) International Patent Classification (IPC):
*H04N 25/76* (2023.01)     *H01L 31/107* (2006.01)
*H01L 31/02* (2006.01)

(52) Cooperative Patent Classification (CPC):
H04N 25/773; H04N 25/76; H10F 30/225;
H10F 77/00

(86) International application number:
PCT/KR2022/021070

(87) International publication number:
WO 2024/128385 (20.06.2024 Gazette 2024/25)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 12.12.2022 KR 20220172252

(71) Applicant: XO Semiconductor Inc.
Chuncheon-si, Gangwon-do 24329 (KR)

(72) Inventors:
- CHAE, Youngcheol
  Seoul 06276 (KR)
- PARK, Byungchoul
  Seoul 06298 (KR)

(74) Representative: Jung, Minkyu
Wuesthoff & Wuesthoff
Patentanwälte und Rechtsanwalt PartG mbB
Schweigerstraße 2
81541 München (DE)

(54) **SINGLE-PHOTON AVALANCHE DIODE-BASED IMAGE SENSOR AND METHOD FOR DRIVING SAME**

(57) According to an embodiment of the present disclosure, a single-photon avalanche diode-based image sensor may comprise: a single-photon avalanche diode (SPAD) which generates a plurality of pulses corresponding to a plurality of photons, received during a predetermined exposure time, respectively; a front-end circuit which receives a set of pulses received during a partial time of the exposure time among the plurality of pulses; a counter which counts the number of pulses in the set of pulses; and a global clock which provides a plurality of clock pulses to the front-end circuit from after the partial time, wherein the quality of an image acquired using the SPAD is determined based on the timing of the global clock.

[FIG. 1]

*SPAD : Single-Photon Avalanche Diode

100

EP 4 637 177 A1

# Description

## Technical Field

The present disclosure relates to a single-photon avalanche diode-based image sensor and a method for driving the same.

## Background Art

A single-photon avalanche diode (SPAD) is a sensing technology that detects faint light signals at a photon level. In particular, the single-photon avalanche diode has very high sensitivity because it uses avalanche multiplication to amplify a single incident photon, making it very easy to photograph in dark environments.

Meanwhile, in the single-photon avalanche diode, an operation of counting trigger pulses generated by photons is required. However, when a counter with a large number of bits is used to count a large number of photons, the size of a circuit increases, which causes the problem of increased power consumption.

The present disclosure was derived from research conducted as part of the development of a 20 x 20cm large-area hybrid X-ray video detector based on a global shutter (Project ID: 1711138024, Project Number: KMDF_PR_20200901_0048-01, Research Project Name: Pan-Ministry Full-Cycle Medical Device R&D Project (Ministry of Science and ICT, Ministry of Health and Welfare, and Ministry of Trade, Industry and Energy), Project Management Agency: Pan-Ministry Full-Cycle Medical Device Research and Development Project Group, Project Executing Agency: Rayence Co., Ltd., Research Period: March 1, 2021 ~ December 31, 2022).

Meanwhile, Korean government, which provided the task, has no property interest in any aspect of the present disclosure.

## Disclosure

## Technical Problem

In order to solve the above-described problem, the present disclosure provides a single-photon avalanche diode-based image sensor that reduces power consumption by estimating the number of total pulses (i.e., total photons) by utilizing an overflow time point of a counter.

## Advantageous Effects

According to some embodiments of the present disclosure, power consumed by a counter can be significantly reduced by counting only a portion of total photons received in a single-photon avalanche and estimating the number of the total photons by utilizing an overflow time point of the counter.

According to some embodiments of the present disclosure, images with excellent image quality can be obtained depending on illumination conditions.

## Description of Drawings

FIG. 1 is a block diagram showing the configuration of a single-photon avalanche diode-based image sensor according to an embodiment of the present disclosure.
FIG. 2 is a graph illustrating a method for calculating the total number of photons received by the single-photon avalanche diode-based image sensor according to an embodiment of the present disclosure.
FIG. 3 is a graph showing clock pulses of a global clock provided to provide clock pulse(s) to a front-end circuit according to an embodiment of the present disclosure.
FIG. 4 is an example showing the timing of the global clock according to an embodiment of the present disclosure.
FIGS. 5a and 5b are graphs illustrating the extrapolated gain of a global clock according to an embodiment of the present disclosure.

Best Mode

According to an embodiment of the present disclosure, a single-photon avalanche diode-based image sensor includes: a single-photon avalanche diode (SPAD) configured to generate a plurality of pulses corresponding to a plurality of photons, received during a predetermined exposure time, respectively, a front-end circuit configured to receive a set of pulses received during a portion of the exposure time among the plurality of pulses, a counter configured to count the number of pulses in the set of pulses, and a global clock configured to provide a plurality of clock pulses to the front-end circuit starting after the portion of the exposure time, wherein a quality of an image acquired by using the single-photon avalanche diode may be determined based on timing of the global clock.

According to an embodiment, at least a portion of the timing of the global clock may be determined based on the number of bits of the counter.

According to an embodiment, at least a portion of the timing of the global clock may be configured to have a positive linear relationship with respect to the timing of the exposure time.

According to an embodiment, at least a portion of the timing of the global clock may be configured to have a positive linear relationship with respect to the square root of the timing of the exposure time.

According to an embodiment, at least a portion of the timing of the global clock may be configured to have a positive linear relationship with respect to the log of the timing of the exposure time.

According to an embodiment, at least a portion of the timing of the global clock may be configured to have a negative linear relationship with respect to the timing of the exposure time.

According to an embodiment, the image sensor may further include a processor configured to determine the timing of the global clock based on the number of a plurality of photons received during the exposure time.

According to an embodiment, an endpoint of the portion of the exposure time may be based on the overflow time point of the counter counting the number of pulses in the set of pulses.

According to another embodiment of the present disclosure, a method for driving a single-photon avalanche diode-based image sensor includes: generating, by a single-photon avalanche diode, a plurality of pulses corresponding to a plurality of photons, received during a predetermined exposure time, respectively, receiving, by a front-end circuit, a set of pulses received during a portion of the exposure time among the plurality of pulses, counting, by a counter, the number of pulses in the set of pulses, and providing, by a global clock, a plurality of clock pulses to the front-end circuit from after the portion of the exposure time, wherein a quality of an image acquired by using the single-photon avalanche diode may be determined based on timing of the global clock.

According to another embodiment of the present disclosure, a computer program recorded on a computer-readable recording medium may be provided to execute the method for driving the single-photon avalanche diode-based image sensor.

**Mode for Invention**

Below, specific details for implementing the present disclosure are described in detail with reference to the attached drawings. However, in the description below, specific descriptions of widely known functions or configurations will be omitted if there is a risk of unnecessarily obscuring the gist of the present disclosure.

In the attached drawings, identical or corresponding components are given the same reference numerals. Additionally, in the description of the embodiments below, redundant description of identical or corresponding components may be omitted. However, the omission of a description of a component is not intended to imply that such component is not included in any embodiment.

The advantages and features of the disclosed embodiments and the methods of achieving them will be apparent with reference to the embodiments described below together with the accompanying drawings. However, the present disclosure is not limited to the embodiments disclosed below and may be implemented in various different forms, and the present embodiments are provided only to make the present disclosure complete and to fully inform those skilled in the art of the scope of the present disclosure.

Terms used in this specification will be briefly described, and the disclosed embodiments will be described in detail. The terms used in this specification have been selected from commonly used terms as much as possible while considering the functions in the present disclosure, but may vary depending on the intention of engineers working in the relevant field, case law, the emergence of new technologies, etc. Additionally, in certain cases, there are terms arbitrarily selected by the applicant, and in this case, meanings of the terms will be described in detail in the description of the relevant invention. Therefore, the terms used in the present disclosure should be defined based on the meaning of the terms and the overall content of the present disclosure, rather than simply the names of the terms.

In this specification, singular expressions include plural expressions unless the context clearly specifies that they are singular. In addition, plural expressions include singular expressions unless the context clearly specifies that they are plural. When a part throughout this specification is described to "include" a component, this does not mean that the part excludes other components, but rather that the part may include other components, unless otherwise stated.

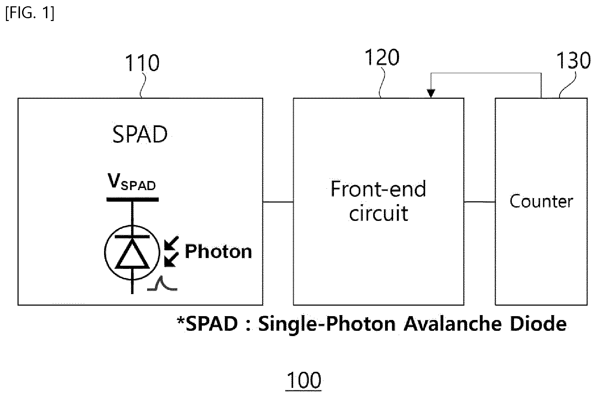

FIG. 1 is a block diagram showing the configuration of a single-photon avalanche diode-based image sensor according to an embodiment of the present disclosure. Simply put, an image sensor 100 may receive a plurality of photons from outside and generate an image by counting the number of the plurality of received photons. In this case, the image sensor 100 may consume a significant amount of power in counting photon(s). To this end, the present disclosure provides the image sensor 100 which reduces power consumption by counting photons only up to a predetermined number and estimating the total number of photons received by using information about a time point at which the corresponding counting ends. As illustrated, the image sensor 100 may include at least one of a single-photon avalanche diode 110, a front-end circuit 120, and a counter 130.

The single-photon avalanche diode 110 may receive the plurality of photons from the outside and generate a plurality of pulses corresponding to the plurality of received photons, respectively. For example, when N photons (here, N is a natural number) are received by the single-photon avalanche diode 110, the single-photon avalanche diode 110 may generate N pulses. After that, the plurality of pulses generated may be transmitted to the front-end circuit.

The single-photon avalanche diode 110 may receive the plurality of photons from the outside for a predetermined exposure time and generate the plurality of pulses corresponding to the plurality of received photons, respectively. For example, when N photons (here, N is a natural number) are received from 0[ms] to 16[ms] by the single-photon avalanche diode 110, the single-photon avalanche diode 110 may generate N pulses. After that, at least some of the plurality of pulses generated may be transmitted to the front-end circuit.

The front-end circuit 120 may receive the plurality of pulses generated by the single-photon avalanche diode 110. In this case, the plurality of pulses may refer to a plurality of pulses received by the single-photon avalanche diode 110 during the exposure time. For example, the front-end circuit 120 may receive N pulses from the single-photon avalanche diode 110 when the N photons (here, N is a natural number) are received by the single-photon avalanche diode 110 from 0[ms] to 16[ms]. Additionally or alternatively, the front-end circuit 120 may receive at least some of the plurality of pulses generated by the single-photon avalanche diode 110. For example, the front-end circuit 120 may receive $N_{OF}$ pulses (here, $N_{OF}<N$) received from 0[ms] to $T_{OF}$[ms] (where $T_{OF}<16$) when N photons (here, N is a natural number) are received from 0[ms] to 16[ms] by the single-photon avalanche diode 110. For another example, the front-end circuit 120 may receive $N_{OF}$ pulses (here, $N_{OF}<N$) received from $T_{OF1}$[ms] to $T_{OF2}$[ms] (wherein, $0<T_{OF1}<T_{OF2}\leq16$) when N photons (here, N is a natural number) are received from 0[ms] to 16[ms] by the single-photon avalanche diode 110.

The front-end circuit 120 may receive a plurality of clock pulses generated from an external device (e.g., a global clock). In this case, the plurality of clock pulses may refer to a plurality of clock pulses generated during the exposure time. For example, the front-end circuit 120 may receive M clock pulses from 0[ms] to 16[ms]. Additionally or alternatively, the front-end circuit 120 may receive a plurality of clock pulses generated during a portion of an overall exposure time. For example, the front-end circuit 120 may receive clock pulses generated between $T_{OF}$[ms] and 16[ms] during an exposure time ranging from 0[ms] to 16[ms]. For another example, the front-end circuit 120 may receive clock pulses generated between 0[ms] and $T_{OF}$[ms] during the exposure time ranging from 0[ms] to 16[ms].

The front-end circuit 120 may initiate receiving a plurality of clock pulses generated from the external device in response to a signal received from the counter 130. In this case, the signal received from the counter 130 may refer to a signal generated in response to the counter 130 overflowing. More specifically, the signal received from the counter 130 may refer to a signal transmitted to the front-end circuit 120 in response to the overflowing of the counter 130 counting the plurality of pulses received from the single-photon avalanche diode 110 via the front-end circuit 120. For example, when the exposure time is from 0[ms] to 16[ms], the counter 130 with N bits may overflow after counting $2^{(N-1)}$ pulses received from the single-photon avalanche diode 110 through the front-end circuit 120 by using N-1 bits from 0[ms]. In this case, a value indicating an overflow is input into the remaining one bit of the N bits of the counter 130 that is not used for counting, and in response, the counter 130 may transmit a signal to the front-end circuit 120 at $T_{OF}$[ms]. After that, in response to the signal received from the counter 130, the front-end circuit 120 may stop receiving pulses from the single-photon avalanche diode 110 and initiate receiving clock pulses from the external device. That is, the front-end circuit 120 may receive a plurality of pulses from the single-photon avalanche diode 110 from 0[ms] to $T_{OF}$[ms], and may receive a plurality of clock pulses from the external device from $T_{OF}$[ms] to 16[ms]. Meanwhile, a MUX element may be used to switch the operation of the front-end circuit 120 from an operation of counting pulses received from the single-photon avalanche diode 110 to an operation of receiving clock pulses from the external device as described above.

The counter 130 may count the number of pulse(s) input to the front-end circuit 120. For example, the counter 130 may count the number of the plurality of pulses input to the front-end circuit 120 from the single-photon avalanche diode 110 from 0[ms] to $T_{OF}$[ms]. As an additional or alternative example, the counter 130 may count the number of a plurality of clock pulses input to the front-end circuit 120 from $T_{OF}$[ms] to 16[ms].

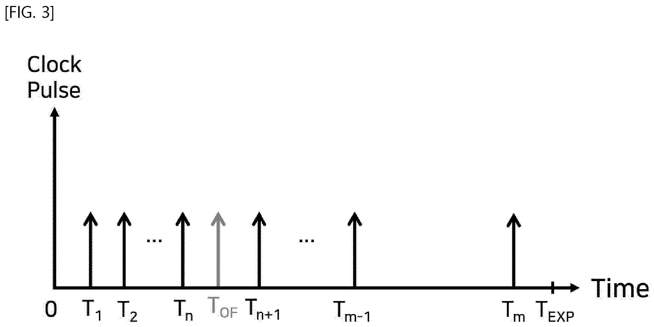

Meanwhile, although not shown in FIG. 1, the image sensor 100 may further include a global clock (not shown) configured to generate the clock pulses described above. In this case, the total number of clock pulses generated by the global clock during the exposure time may be equal to the number of a plurality of pulses counted until just before the counter 130 with N bits (in this case, only N-1 bits of the counter 130 are used for counting) overflows (i.e., until before $T_{OF}$[ms] in the above example). That is, when the counter 130 with N bits is used, the total number of clock pulses generated by the global clock during the exposure time may be preset to $2^{(N-1)}$. A detailed description of this will be provided later with reference to FIG. 3.

In addition, in FIG. 1, for convenience of explanation, the image sensor 100 is illustrated as including one single-photon avalanche diode 110, but is not limited thereto. That is, the image sensor 100 may include a plurality of single-photon avalanche diodes. For example, the front-end circuit 120 may be connected to a plurality of single-photon avalanche diodes arranged in each of a plurality of pixels.

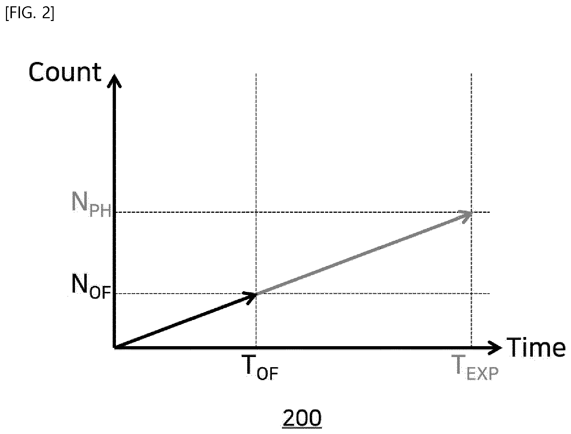

FIG. 2 is a graph 200 illustrating a method for calculating the total number of photons received by the single-photon avalanche diode-based image sensor (e.g., the image sensor 100) according to an embodiment of the present disclosure. Here, it is assumed that the counter (e.g., the counter 130) provided to count pulses generated by the single-photon avalanche diode (e.g., the single-photon avalanche diode 110) and/or the global clock consists of N bits, and only N-1 bits are used for counting. In addition, $T_{OF}$ in FIG. 2 indicates a time point at which the counter overflows as a result of counting a plurality of pulses received from the single-photon avalanche diode.

As described above in FIG. 1, the counter counts only $2^{(N-1)}$ pulses generated by the single-photon avalanche diode during time between 0 and $T_{OF}$ in order to reduce power consumption. In this case, since time $T_{EXP}$ during which the image sensor is exposed to a light source has a predetermined value, the total number of photons ($N_{OH}$) received by the image sensor during the exposure time may be calculated according to the following mathematical expression 1. In this case, the power of counting photons may be saved as much as $N_{PH}/N_{OF}$. Here, $N_{OF}$ represents the number of photons received by the image sensor from a time point at which the exposure of the image sensor to the light source begins until a time point at which the counter overflows. However, in order to calculate the number ($N_{OH}$) of photons by using mathematical expression 1, it is first required to know the $T_{OF}$, which indicates the time point at which the counter overflows. A method for estimating $T_{OF}$ will be described later with reference to FIG. 3.

[Mathematical expression 1]

$$N_{PH} = N_{OF} * (T_{EXP} / T_{OF})$$

FIG. 3 is a graph 300 showing clock pulses of the global clock provided to provide clock pulse(s) to the front-end circuit according to an embodiment of the present disclosure. Likewise, it is assumed that the counter (e.g., the counter 130) provided to count pulses generated by the single-photon avalanche diode (e.g., the single-photon avalanche diode 110) and/or the global clock consists of N bits, and only N-1 bits are used for counting. Additionally, $T_{OF}$ and $T_{EXP}$ represent the time point at which the counter overflows and time during which the single-photon avalanche diode is exposed to the light source, respectively, as shown in $T_{OF}$ and $T_{EXP}$ in FIG. 2.

As described in FIG. 1, the total number M of clock pulses generated during the exposure time is set to be equal to the number (i.e., $2^{(N-1)}$) of a plurality of pulses generated by the single-photon avalanche diode between 0 and $T_{OF}$. In addition, the timing of each of the entire clock pulses are set to include at least one function of a log function, a linear function, or a square-root function with respect to the exposure time. For example, clock pulses between 0 and $T_{OF}$ may be provided in the form of a linear function, and clock pulses between $T_{OF}$ and $T_{EXP}$ may be provided in the form of a log function. That is, a time point of each of all clock pulses has a value predetermined based on the shape of a selected function. Accordingly, the time point $T_n$ of the last clock pulse occurring before $T_{OF}$ may be calculated by using the sequence number (here, n+1) and time point $T_{n+1}$ of a clock pulse occurring first after $T_{OF}$. In this case, since the overflow of the counter occurs at a time point between $T_n$ and $T_{n+1}$, $T_{OF}$ may be estimated as any value between $N_{OF}*(T_{EXP}/T_n)$ and $N_{OF}*(T_{EXP}/T_{n+1})$, as in mathematical expression 2 below.

[Mathematical expression 2]

$$N_{PH} = N_{OF} * \left(\frac{T_{EXP}}{T_n}\right) \sim N_{OF} * \left(\frac{T_{EXP}}{T_{n+1}}\right)$$

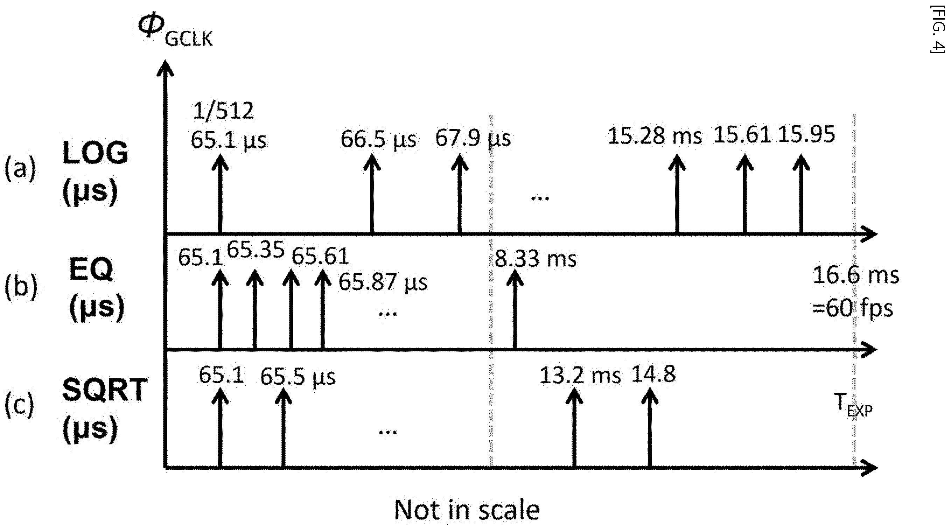

FIG. 4 is an example showing the timing of the global clock according to an embodiment of the present disclosure. Here, the global clock $\phi_{GCLK}$ may refer to a device that generates the above-described clock pulse at a predetermined timing. In FIG. 4, N represents the number of bits used for pulse counting in the counter. Additionally, $N_{EX}$ represents the number of photons received by the single-photon avalanche diode from a starting point of the exposure time to an endpoint (e.g., $T_{EXP}$ in FIG. 2) of the exposure time. Hereinafter, a method for estimating $N_{EX}$ based on various types of global clocks will be described.

FIG. 4(a) shows an example in which at least a portion of the timing of the global clock has a positive linear relationship with respect to the log (or a log value) of the exposure time. Specifically, the timing of the global clock and the log value of the exposure time $T_{EXP}$ may have a proportional relationship. In this case, the overflow time point $T_{SAT}$ of the counter according to the number M_LOG of the clock pulses of the global clock counted by the counter may be obtained through a lookup table, and $N_{EX}$ may be determined by using the reciprocal of the obtained overflow time point $T_{SAT}$ as in the following mathematical expression 3. Meanwhile, in the present disclosure, $T_{SAT}$ is interpreted as having the same meaning as $T_{OF}$.

[Mathematical expression 3]

$$N_{EX} = 2^N * T_{EXP} / T_{SAT}$$

FIG. 4(b) shows an example in which at least a portion of the timing of the global clock has a positive linear relationship with respect to the timing of the exposure time. Specifically, an interval between a first clock pulse (e.g., 65.1us) and a next second clock pulse (e.g., 66.5us) generated by the global clock may have a value equal to the total exposure time $T_{EXP}$ divided by $2^N$. In this case, $N_{EX}$ may be calculated by using the reciprocal of the number M_EQ of clock pulses of the global clock counted by the counter, as in the following mathematical expression 4.

[Mathematical expression 4]

$$N_{EX} = 2^N * 2^N / M_{EQ}$$

FIG. 4(c) shows an example in which at least a portion of the timing of the global clock has a positive linear relationship with respect to the square root of the timing of the exposure time. Specifically, the timing of the global clock and the square root of the exposure time $T_{EXP}$ may have a proportional relationship. In this case, the overflow time point $T_{SAT}$ of the counter according to the number M_SQRT of clock pulse(s) of the global clock counted by the counter may be obtained through a lookup table, and $N_{EX}$ may be determined by using the reciprocal of the obtained overflow time point $T_{SAT}$ as in the following mathematical expression 5.

[Mathematical expression 5]

$$N_{EXP} = 2^N * T_{EXP} / T_{SAT}$$

Additionally or alternatively, although not shown in FIG. 4, at least a portion of the timing of the global clock may be configured to have a negative linear relationship with respect to the timing of the exposure time. In this case, $N_{EX}$ may be calculated according to the following mathematical expression 6.

[Mathematical expression 6]

$$N_{EX} = 2^N * (M_{EQAL} + 1)$$

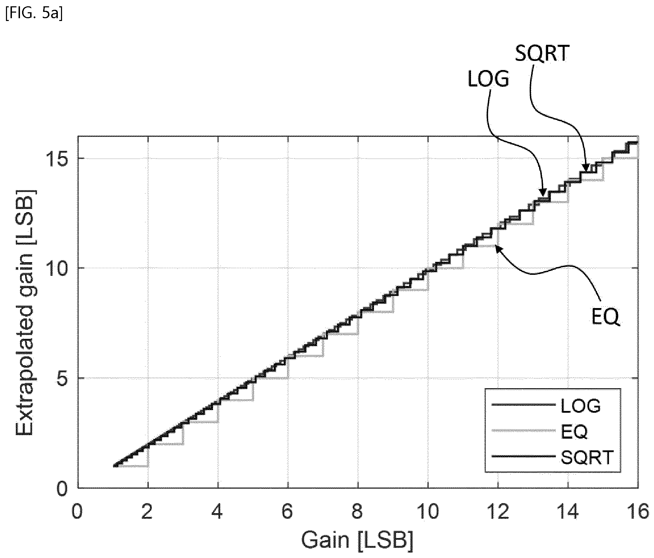

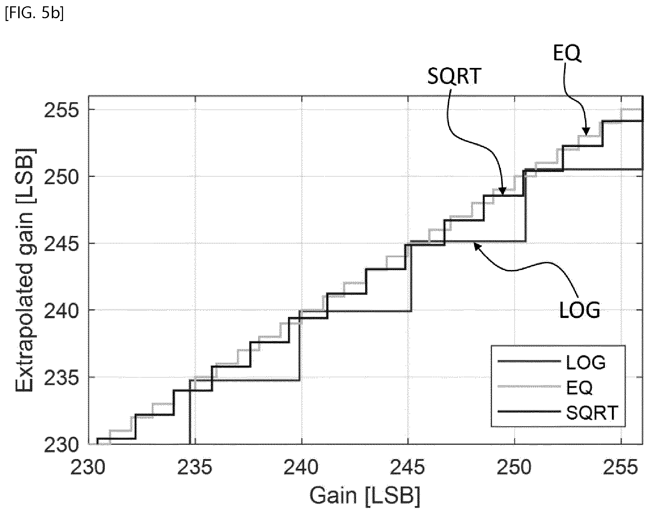

FIGS. 5a and 5b are graphs illustrating the extrapolated gain of a global clock according to an embodiment of the present disclosure. As illustrated, the global clock of an EQ type may have an extrapolated gain which remains constant, and be advantageous in acquiring images in low illumination and/or medium illumination conditions. Accordingly, although not shown in FIGS. 5a and 5b, a global clock according to mathematical expression 6, on the other hand, may be advantageous in acquiring images in medium illumination and/or high illumination conditions. On the other hand, an SQRT-type global clock shows the increasing pattern of an extrapolated gain, but the rate of change of the extrapolated gain decreases. Additionally, an LOG-type global clock shows the increasing pattern of an extrapolated gain, and the rate of change of the extrapolated gain also increases.

The single-photon avalanche diode-based image sensor of the present disclosure may determine the type of global clock depending on an illumination environment based on the type-specific extrapolated gain of the global clock described above. Specifically, the single-photon avalanche diode-based image sensor may include a processor that determines the timing of the global clock based on the number of a plurality of photons received during the exposure time. In this case, the processor may select an EQ-type global clock as a global clock connected to the front-end circuit (e.g. the front-end circuit 120) in a low illumination environment. In addition, the processor may select a global clock according to mathematical expression 6 as a global clock in a high illumination environment.

Additionally or alternatively, the processor may use any combination of the four types of global clocks described above, depending on an illumination environment. For example, the processor may determine to use an EQ-type global clock from the starting point to the middle time point during time for which the counter is counting the global clock, and to use a SQRT- type global clock from the middle time point to the endpoint. That is, the processor may determine the timing of the global clock based on the number of a plurality of photons received during the exposure time.

The foregoing description of the present disclosure is provided to enable those skilled in the art to perform or use the present disclosure. Various modified examples of the present disclosure will be readily apparent to those skilled in the art, and general principles defined herein may be applied to various embodiments without departing from the spirit or scope of the present disclosure. Accordingly, the present disclosure is not intended to be limited to the examples described herein but is to be accorded with the widest scope consistent with the principles and novel features disclosed herein.

Although the present disclosure has been described in connection with some embodiments herein, it should be understood that various modifications and changes may be made without departing from the scope of the present disclosure as understood by those skilled in the art to which the present disclosure pertains. Furthermore, such modifications and changes should be considered to fall within the scope of the claims appended hereto.

**Claims**

1. A single-photon avalanche diode-based image sensor comprising:

   a single-photon avalanche diode (SPAD) configured to generate a plurality of pulses corresponding to each of a plurality of photons received during a predetermined exposure time;
   a front-end circuit configured to receive a set of pulses, which are received during a portion of time within the exposure time among the plurality of pulses;
   a counter configured to count the number of pulses in the set of pulses; and
   a global clock configured to provide a plurality of clock pulses to the front-end circuit after the portion of the exposure time,
   wherein a quality of an image acquired by using the single-photon avalanche diode is determined based on timing of the global clock.

**2.** The image sensor of claim 1, wherein at least a portion of the timing of the global clock is determined based on the number of bits of the counter.

**3.** The image sensor of claim 1, wherein at least a portion of the timing of the global clock has a positive linear relationship with respect to timing of the exposure time.

**4.** The image sensor of claim 1, wherein at least a portion of the timing of the global clock has a positive linear relationship with respect to a square root of timing of the exposure time.

**5.** The image sensor of claim 1, wherein at least a portion of the timing of the global clock has a positive linear relationship with respect to log of timing of the exposure time.

**6.** The image sensor of claim 1, wherein at least a portion of the timing of the global clock has a negative linear relationship with respect to timing of the exposure time.

**7.** The image sensor of claim 1, further comprising:
a processor configured to determine the timing of the global clock based on the number of the plurality of photons received during the exposure time.

**8.** The image sensor of claim 1, wherein an endpoint of the portion of the exposure time is based on an overflow time point of the counter counting the number of pulses in the set of pulses.

**9.** A method for driving a single-photon avalanche diode-based image sensor, the method comprising:

generating, by a single-photon avalanche diode, a plurality of pulses corresponding to a plurality of photons, received during a predetermined exposure time, respectively;
receiving, by a front-end circuit, a set of pulses received during a portion of the exposure time among the plurality of pulses;
counting, by a counter, the number of pulses in the set of pulses; and
providing, by a global clock, a plurality of clock pulses to the front-end circuit starting after the portion of the exposure time,
wherein a quality of an image acquired by using the single-photon avalanche diode is determined based on timing of the global clock.

**10.** A non-transitory computer-readable recording medium having a program for executing the method for driving a single-photon avalanche diode-based image sensor described in claim 9.

[FIG. 1]

*SPAD : Single-Photon Avalanche Diode

100

[FIG. 2]

200

[FIG. 3]

[FIG. 4]

[FIG. 5a]

[FIG. 5b]

## INTERNATIONAL SEARCH REPORT

| | International application No. |
|---|---|
| | **PCT/KR2022/021070** |

| A. | CLASSIFICATION OF SUBJECT MATTER |
|---|---|

**H04N 25/76**(2023.01)i; **H01L 31/107**(2006.01)i; **H01L 31/02**(2006.01)i

According to International Patent Classification (IPC) or to both national classification and IPC

| B. | FIELDS SEARCHED |
|---|---|

Minimum documentation searched (classification system followed by classification symbols)

H04N 25/76(2023.01); G01S 17/10(2006.01); G01S 7/486(2006.01); H04N 13/125(2018.01); H04N 13/239(2018.01); H04N 5/353(2011.01); H04N 5/355(2011.01); H04N 5/3745(2011.01); H04N 5/378(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 포톤 (photon), 펄스 (pulse), 카운팅 (counting), 이미지 (image), SPAD (single photon avalanche diode)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | US 2019-0250257 A1 (SENSE PHOTONICS, INC.) 15 August 2019 (2019-08-15)<br>See paragraphs [0039]-[0135]. | 1-10 |
| A | US 2022-0264047 A1 (ECOLE POLYTECHNIQUE FEDERALE DE LAUSANNE (EPFL)) 18 August 2022 (2022-08-18)<br>See paragraphs [0053]-[0084]. | 1-10 |
| A | US 2022-0006965 A1 (SONY SEMICONDUCTOR SOLUTIONS CORPORATION) 06 January 2022 (2022-01-06)<br>See claims 1-12. | 1-10 |
| A | US 2021-0385424 A1 (STMICROELECTRONICS (RESEARCH & DEVELOPMENT) LIMITED) 09 December 2021 (2021-12-09)<br>See paragraphs [0028]-[0094]. | 1-10 |
| A | KR 10-2020-0011351 A (SAMSUNG ELECTRONICS CO., LTD.) 03 February 2020 (2020-02-03)<br>See claims 1-9. | 1-10 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **30 August 2023** | **30 August 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2022/021070**

| Patent document cited in search report | | | Publication date (day/month/year) | Patent family member(s) | | | Publication date (day/month/year) |
|---|---|---|---|---|---|---|---|
| US | 2019-0250257 | A1 | 15 August 2019 | CN | 111868556 | A | 30 October 2020 |
| | | | | EP | 3732501 | A2 | 04 November 2020 |
| | | | | EP | 3732501 | A4 | 25 August 2021 |
| | | | | JP | 2021-513087 | A | 20 May 2021 |
| | | | | KR | 10-2020-0110451 | A | 23 September 2020 |
| | | | | US | 11467286 | B2 | 11 October 2022 |
| | | | | US | 2021-0181547 | A1 | 17 June 2021 |
| | | | | WO | 2020-033001 | A2 | 13 February 2020 |
| | | | | WO | 2020-033001 | A3 | 28 May 2020 |
| US | 2022-0264047 | A1 | 18 August 2022 | WO | 2021-018403 | A1 | 04 February 2021 |
| US | 2022-0006965 | A1 | 06 January 2022 | JP | 2020-096347 | A | 18 June 2020 |
| | | | | US | 11678078 | B2 | 13 June 2023 |
| | | | | WO | 2020-110484 | A1 | 04 June 2020 |
| US | 2021-0385424 | A1 | 09 December 2021 | US | 11477431 | B2 | 18 October 2022 |
| KR | 10-2020-0011351 | A | 03 February 2020 | CN | 110779459 | A | 11 February 2020 |
| | | | | CN | 110779459 | B | 05 August 2022 |
| | | | | DE | 102019107807 | A1 | 30 January 2020 |
| | | | | JP | 2020-016654 | A | 30 January 2020 |
| | | | | TW | 202018329 | A | 16 May 2020 |
| | | | | US | 11294039 | B2 | 05 April 2022 |
| | | | | US | 2020-0033456 | A1 | 30 January 2020 |
| | | | | US | 2022-0146683 | A1 | 12 May 2022 |

Form PCT/ISA/210 (patent family annex) (July 2022)